(19) **Europäisches Patentamt / European Patent Office / Office européen des brevets**

(11) **EP 3 531 141 B1**

(12) **EUROPÄISCHE PATENTSCHRIFT**

(45) Veröffentlichungstag und Bekanntmachung des Hinweises auf die Patenterteilung:
**21.09.2022 Patentblatt 2022/38**

(21) Anmeldenummer: **19163252.0**

(22) Anmeldetag: **23.06.2010**

(51) Internationale Patentklassifikation (IPC):
***G01R 19/25*** (2006.01)

(52) Gemeinsame Patentklassifikation (CPC):
**F03D 9/255; G01R 19/2513; H02J 3/381;**
H02J 3/44; H02J 2300/28; Y02E 10/72; Y02E 10/76

(54) **VERFAHREN UND VORRICHTUNG ZUR NETZZUSTANDSBEOBACHTUNG**

METHOD AND DEVICE FOR NETWORK CONDITION MONITORING

PROCÉDÉ ET DISPOSITIF D'OBSERVATION DE L'ÉTAT DU RÉSEAU

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**BA RS**

(30) Priorität: **29.06.2009 DE 102009031017**

(43) Veröffentlichungstag der Anmeldung:
**28.08.2019 Patentblatt 2019/35**

(62) Dokumentnummer(n) der früheren Anmeldung(en) nach Art. 76 EPÜ:
**10727410.2 / 2 449 387**

(73) Patentinhaber: **Wobben Properties GmbH**
**26607 Aurich (DE)**

(72) Erfinder:
• **Beekmann, Alfred**
  **26639 Wiesmoor (DE)**
• **Diedrichs, Volker**
  **18209 Bad Doberan (DE)**

(74) Vertreter: **Eisenführ Speiser**
**Patentanwälte Rechtsanwälte PartGmbB**
**Postfach 10 60 78**
**28060 Bremen (DE)**

(56) Entgegenhaltungen:
WO-A1-2008/120282    WO-A2-2007/011862
WO-A2-2008/011522    AU-B2- 460 336
JP-A- 2000 329 803    JP-A- 2003 344 463
US-A- 5 278 773    US-A1- 2007 279 039

• ECKHARDT V ET AL: "Dynamic measuring of frequency and frequency oscillations in multiphase power systems", IEEE TRANSACTIONS ON POWER DELIVERY, IEEE SERVICE CENTER, NEW YORK, NY, US, Bd. 4, Nr. 1, 1. Januar 1989 (1989-01-01), Seiten 95-102, XP011479876, ISSN: 0885-8977, DOI: 10.1109/61.19193
• PHADKE A G ET AL: "A New Measurement Technique for Tracking Voltage Phasors, Local System Frequency, and Rate of Change of Frequency", IEEE TRANSACTIONS ON POWER APPARATUS AND SYSTEMS, IEEE INC. NEW YORK, US, Bd. PAS-100, Nr. 5, 1. Mai 1983 (1983-05-01), Seiten 1025-1038, XP011170046, ISSN: 0018-9510
• MILANEZ ET AL: "A new method for real time computation of power quality indices based on instantaneous space phasors", ELECTRIC POWER SYSTEMS RESEARCH, ELSEVIER, AMSTERDAM, NL, Bd. 77, Nr. 1, 1. Januar 2007 (2007-01-01), Seiten 93-98, XP005607146, ISSN: 0378-7796, DOI: 10.1016/J.EPSR.2006.02.001

EP 3 531 141 B1

**Beschreibung**

Die vorliegende Erfindung betrifft ein Verfahren zum Erfassen elektrischer Größen eines 3-phasigen Wechselspannungsnetzes nach Anspruch 1 mit einer ersten, zweiten und dritten Phase. Weiterhin betrifft die vorliegende Erfindung ein Verfahren zum Einspeisen elektrischer Energie in ein elektrisches Wechselspannungsnetz nach Anspruch 10. Weiterhin betrifft die vorliegende Erfindung eine Messvorrichtung zum Erfassen elektrischer Größen eines 3-phasigen Wechselspannungsnetzes nach Anspruch 13 sowie eine Einspeisevorrichtung zum Einspeisen elektrischer Energie in ein Wechselspannungsnetz nach Anspruch 14. Außerdem betrifft die vorliegende Erfindung auch eine Windenergieanlage nach Anspruch 15, die eine Messvorrichtung nach Anspruch 13 und/oder eine Einspeisevorrichtung nach Anspruch 14 umfasst.

Insbesondere um elektrische Energie in ein bestehendes elektrisches Wechselspannungsnetz einzuspeisen, ist es erforderlich, dieses möglichst genau zu kennen. Die Kenntnis der Frequenz der Wechselspannung in dem Netz sowie Beträge und Phasen der Spannungen sind von Bedeutung. Aber auch für andere Zwecke, die mit der Einspeisung zusammenhängen können, wie beispielsweise das Erkennen von Störungen im Netz, ist eine möglichst genaue und möglichst zeitnahe Erfassung vornehmlich der elektrischen Spannungen des Netzes wünschenswert.

Um Frequenz und Phasenwinkel der Wechselspannung eines elektrischen Wechselspannungsnetzes zu erfassen, werden üblicherweise Nulldurchgänge der Spannung erfasst. Der zeitliche Abstand zweier benachbarter Spannungsnulldurchgänge entspricht einer halben Periodendauer, woraus die Frequenz berechnet werden kann. Somit ist auch die Phasenlage aus dem Nulldurchgang und der Frequenz oder den beiden Nulldurchgängen bestimmbar.

Nachteilig hierbei ist insbesondere, dass entsprechend zumindest die Zeitdauer einer Halbperiode nötig ist, um die Frequenz und damit Frequenzänderungen zu erfassen. Gleichzeitig kann die Qualität bei solchen Messverfahren ungenügend sein. Insbesondere für Wechselspannungsnetze, die zunehmend durch dezentrale Energieversorgung gespeist und auch gestützt werden, ist eine möglichst schnelle Messung mit möglichst hoher Qualität von Bedeutung. Auch das zuverlässige und schnelle Erfassen von Netzstörungen, wie das Auftreten von Kurzschlüssen, gewinnt zunehmend an Bedeutung.

Aufgabe der vorliegenden Erfindung war es somit, ein bezogen auf wenigstens eines der oben genannten Nachteile verbessertes Verfahren bzw. entsprechende Vorrichtung vorzuschlagen. Insbesondere sollte ein Messverfahren vorgeschlagen werden, das möglichst in Bezug auf Geschwindigkeit und Qualität verbessert ist. Zumindest war ein alternatives Messverfahren und ein alternatives Verfahren zum Einspeisen sowie entsprechende Vorrichtungen vorzuschlagen.

Als Stand der Technik wird an dieser Stelle allgemein auf folgende Dokumente hingewiesen: DE 101 13 786 A1, EP 004 984 A1, XP-11479876 "Dynamic Measuring of Frequency and Frequency Oscillations in Multiphase Power Systems", WO 2008/120282 A1 und DE 199 44 680 A1.

Erfindungsgemäß wird ein Verfahren zum Erfassen elektrischer Größen eines 3-phasigen Wechselspannungsnetzes gemäß Anspruch 1 vorgeschlagen.

Ausgegangen wird von einem 3-phasigen Wechselspannungsnetz mit einer ersten, zweiten und dritten Phase. Die Angabe eines Phasenwinkels bezieht sich nachfolgend grundsätzlich auf die erste Phase, soweit nichts anderes angegeben ist. Indizes von 1 bis 3, insbesondere von Spannungen oder Phasenwinkeln, beziehen sich grundsätzlich auf die erste, zweite bzw. dritte Phase.

In einem Verfahrensschritt wird zu einem ersten Zeitpunkt von der ersten, zweiten und dritten Phase jeweils ein Spannungswert, nämlich eine Strangspannung erfasst bzw. gemessen, also die Spannung bezogen auf den Neutralleiter oder ein anderes neutrales Potential.

Als nächster Schritt erfolgt eine Transformation der zum ersten Zeitpunkt gemessenen Spannungswerte in Polarkoordinaten in eine komplexwertige Größe, wodurch entsprechend ein Betrag und ein Phasenwinkel entsteht. Der Phasenwinkel bezieht sich dabei auf die erste Spannung. Die Transformation kann wie folgt durchgeführt werden:

$$\vec{u} = \left[ u_1 + u_2 \exp\left( j\frac{2}{3}\pi \right) + u_3 \exp\left( j\frac{4}{3}\pi \right) \right]$$

$$U_N = \sqrt{\frac{2}{3}} \sqrt{\left(real\left(\vec{u}\right)\right)^2 + \left(imag\left(\vec{u}\right)\right)^2}$$

$$\varphi_N = \arctan\left(imag\left(\vec{u}\right) / real\left(\vec{u}\right)\right)$$

In einem nächsten Schritt wird das Messen und Transformieren für wenigstens einen weiteren Zeitpunkt wiederholt. Somit liegen zu zumindest zwei Zeitpunkten eine in Polarkoordinaten transformierte Spannungsmessung vor. Aus diesen Werten in Polarkoordinaten werden dann die Frequenz, die Spannungsamplitude und/oder der Phasenwinkel wenigstens einer der Phasen bestimmt.

Üblicherweise dürfte das Verfahren digital umgesetzt werden. In diesem Fall laufen die beschriebenen Verfahrensschritte zumindest teilweise zeitlich gesehen nacheinander ab. Insbesondere wird zu einem ersten Zeitpunkt die Spannung der drei Phasen gemessen, eine Transformation durchgeführt und dann zu einem zweiten danach liegenden Zeitpunkt erneut die Spannungen der drei Phasen gemessen. Grundsätzlich kommt aber auch eine analoge Umsetzung in Betracht, wobei im wesentlichen eine kontinuierliche Messung durchgeführt werden könnte.

Vorzugsweise wird die aktuelle Frequenz, eine Spannungsamplitude und die Phasen der drei Spannungen berechnet. Ebenfalls bevorzugt liegen die Zeitpunkte der Messung um weniger als eine Halbperiode - ausgehend von der erwarteten Frequenz - auseinander.

Vorzugsweise wird zur Bestimmung der einen effektiven Frequenz der drei Wechselspannungen eine Frequenzregelung verwendet,die ausdrücklich nicht nach dem Konzept des phase-lockedloop (PLL) arbeitet und eine erste Hilfsfrequenz ausregelt. Hierfür wird ein Regelkreis verwendet. Die erste Hilfsfrequenz ist im Grunde eine Zustandsgröße und ein Ergebnis dieses Regelkreises, die als Zwischengröße weiter verwertet werden kann. Grundsätzlich kann auch die erste Hilfsfrequenz selbst als erhaltene aktuelle Frequenz verwendet werden.

Aus der Hilfsfrequenz kann ein Hilfswinkel bestimmt werden. Durch Vergleich des Phasenwinkels, der bei der Koordinatentransformation ermittelt wurde, mit dem Hilfsphasenwinkel kann eine Größe zum Generieren der ersten Hilfsfrequenz erzeugt werden.

Vorzugsweise wird zur Frequenzregelung ein erster Differenzwinkel gebildet. Dieser erste Differenzwinkel ergibt sich als Differenz zwischen dem Phasenwinkel, der sich bei der Koordinatentransformation ergibt, und einem ersten um eine Abtastzeit zurückliegenden Hilfsphasenwinkel. Dieser erste Differenzwinkel könnte somit auch als Frequenz oder Differenzfrequenz interpretiert werden, weil jedenfalls die Differenz zwischen einem Phasenwinkel mit einem ein Abtastschritt zurückliegenden Phasenwinkel einer Frequenz entspricht.

Besagter erster Differenzwinkel wird mit einem ersten Verstärkungsfaktor multipliziert und/oder zu einem Anfangsfrequenzwert einer Frequenz addiert, um die erste Hilfsfrequenz zu erhalten. Der erste Hilfsphasenwinkel wird aus der ersten Hilfsfrequenz bestimmt. Als Anfangsfrequenzwert kann eine zu erwartende Frequenz, insbesondere die Nennfrequenz bzw. entsprechend die Nennkreisfrequenz des Netzes, verwendet werden. Vorzugsweise wird zur Verbesserung der Frequenzbestimmung vorgeschlagen, einen zweiten Hilfsphasenwinkel mit einer zweiten Hilfsfrequenz zu bestimmen. Eine solche zweite Hilfsfrequenz kann - ggf. nach Filterung - als erfasste aktuelle Frequenz ausgegeben werden. Vorzugsweise basiert eine solche zweite Hilfsfrequenz und zweiter Hilfsphasenwinkel auf der ersten Hilfsfrequenz und dem ersten Hilfsphasenwinkel.

Vorzugsweise wird die zweite Hilfsfrequenz und der zweite Hilfsphasenwinkel basierend auf einem vorgegebenen, dynamischen Verhalten abhängig von der ersten Hilfsfrequenz und dem ersten Hilfsphasenwinkel bestimmt, insbesondere geregelt.

Es wird vorgeschlagen, ausgehend von dem ersten Hilfsphasenwinkel und dem zweiten Hilfsphasenwinkel einen zweiten Differenzwinkel zu bestimmen. Dieser zweite Differenzwinkel wird als Differenz zwischen dem ersten Hilfsphasenwinkel und dem zweiten, um eine Abtastzeit zurückliegenden, Hilfsphasenwinkel gebildet. Weiterhin wird die erste und zweite Hilfsfrequenz zugrunde gelegt und daraus eine Hilfsdifferenzfrequenz bestimmt. Die Hilfsdifferenzfrequenz wird als Differenz zwischen der zweiten, um eine Abtastzeit zurückliegenden, Hilfsfrequenz und der ersten Hilfsfrequenz gebildet.

Außerdem wird eine Hilfswinkelbeschleunigung aus dem zweiten Differenzwinkel und der Hilfsdifferenzfrequenz gebildet. Diese Hilfswinkelbeschleunigung ist repräsentativ für eine zweite Ableitung des zweiten Hilfsphasenwinkels nach der Zeit und der zweite Hilfsphasenwinkel als auch die zweite Hilfsfrequenz werden aus dieser Hilfswinkelbeschleunigung berechnet. Vorzugsweise wird die Hilfswinkelbeschleunigung als Differenz zwischen dem zweiten Differenzwinkel und der Hilfsdifferenzfrequenz gebildet, wobei der zweite Differenzwinkel und/oder die Hilfsdifferenzfrequenz jeweils mit einem Verstärkungsfaktor multipliziert berücksichtigt werden können.

Insbesondere die Differenzbildung mit der Hilfsdifferenzfrequenz, was auch als Aufschaltung der Hilfsdifferenzfrequenz mit einem Verstärkungsfaktor - der grundsätzlich auch 1 sein könnte - bezeichnet werden kann, wirkt sich je nach Wahl der Verstärkungsfaktoren dämpfend auf die Dynamik der zweiten Hilfsfrequenz aus, soweit die Verfahrensschritte bzw. Verfahrensmerkmale in ihrer Wirkung interpretiert werden können.

Gemäß einer bevorzugten Ausführungsform wird die bei der Transformation erhaltene Spannungsamplitude als erfasste Ausgangsspannung ausgegeben. Außerdem oder alternativ wird gemäß dieser Ausführungsform der bei der Transformation erhaltene Phasenwinkel nach der Zeit differenziert - was diskret oder kontinuierlich erfolgen kann - und als erfasste Frequenz ausgegeben. Alternativ kann dieser differenzierte Phasenwinkel auch als erfasste Vergleichsfrequenz ausgegeben werden, wenn insbesondere eine weitere Größe als erfasste Frequenz ausgegeben wird.

Zusätzlich oder alternativ wird die zweite Hilfsfrequenz als erfasste Frequenz ausgegeben und zusätzlich oder alternativ der zweite Hilfsphasenwinkel als erfasster Phasenwinkel einer Phase, insbesondere der ersten Phase. Eine, mehrere oder alle der besagten Größen können vor dem Ausgeben ggf. geeignet gefiltert werden.

Die auszugebenden Größen, insbesondere die als erfasste Frequenz ausgegebene zweite Hilfsfrequenz und der als erfasste Phasenwinkel ausgegebene zweite Hilfsphasenwinkel bilden somit ein Verfahrensprodukt des Verfahrens. Eine solche ausgegebene erfasste Frequenz und ein solcher ausgegebener erfasster Phasenwinkel zeichnet sich insbesondere durch eine schnelle Erfassung aus. Das heißt, insbesondere die Ausgabe einer erfassten Frequenz, die eine Frequenzänderung des gemessenen Wechselspannungsnetzes in einem Zeitraum kleiner als einer halben Periodendauer aufweist, unterscheidet sich schon darin von einer üblichen Frequenzerfassung durch Messung der Spannungsnulldurchgänge. Falls gewünscht, könnte natürlich auch das erfindungsgemäße Verfahren langsamer ausgelegt bzw. implementiert werden.

Gemäß einer Ausführungsform wird zudem das Wechselspannungsnetz auf das Vorliegen wenigstens einer Netzstörung überwacht. Zu solchen Netzstörungen gehört:

- der Verlust der Winkelstabilität,

- das Auftreten einer Inselnetzbildung,

- das Auftreten eines 3-phasigen Kurzschlusses, und

- das Auftreten eines 2-poligen Kurzschlusses.

Das Auftreten eines 3-phasigen Kurzschlusses kann insbesondere am Einbrechen der drei Strangspannungen und damit am Einbrechen der transformierten Spannungsamplitude erkannt werden. Bei einem 2-poligen Kurzschluss bricht grundsätzlich nur eine Spannung dann ein, wenn auf der d-Seite eines DY-Transformators (Dreieck-Stern-Transformators) gemessen wurde und der 2-polige Kurzschluss auf der D-Steite auftrat. Dies kann beispielsweise an einer oszillierenden Spannungsamplitude der transformierten Spannung erkannt werden.

Beim Verlust der Winkelstabilität, das im Englischen auch als "loss of stability" (LOS) bezeichnet wird, weicht die Differentiation des Phasenwinkels ($\frac{d\varphi}{dt}$) von der Netzfrequenz bzw. der Netzkreisfrequenz ab. Zum Erfassen eines solchen Verlustes der Winkelstabilität ist eine schnelle Winkel- und Frequenzerfassung wünschenswert.

Beim Auftreten einer Inselnetzbildung, die im Englischen auch als "loss of mains" (LOM) bezeichnet wird, bewegt sich die tatsächliche Frequenz allmählich aus dem Bereich der Nennfrequenz heraus und verlässt insbesondere einen vorgegebenen Toleranzbereich. Somit ist davon auszugehen, dass der Netzabschnitt, in dem gemessen wird, Kontakt zu einem größeren Hauptnetz mit einer stabileren Frequenz verloren hat.

Um das Vorliegen einer Netzstörung anzuzeigen, kann ein entsprechendes Signal bereitgestellt werden. Ein solches Signal kann innerhalb einer Prozessoreinheit bereitgestellt werden oder als Ausgabesignal ausgegeben werden. In jedem Fall ist ein solches Signal als Produkt des Verfahrens anzusehen. Insbesondere das schnelle und gezielte Erkennen wenigstens einer der genannten Netzstörungen ist ein angestrebtes Ziel und zeichnet ein solches Signal aus.

Insbesondere zu dem Verlust der Winkelstabilität und der Inselnetzbildung wurde erfindungsgemäß erkannt, dass diese zunehmend bei Netzen mit dezentral einspeisenden Energieversorgern zu erwarten sind. Eine schnelle und zuverlässige Erkennung ist hierbei von Bedeutung, um ggf. schnell und zielgerichtet eingreifen zu können.

Vorzugsweise wird die Messung bzw. Erfassung der elektrischen Größen auf eine Netzstörung hin beobachtet, um eine etwaige Netzstörung zu erkennen. Beim Auftreten einer Netzstörung wird die Erfassung im Sinne einer Schätzung basierend auf zuletzt verwendeten Größen fortgesetzt. Von einer tatsächlichen Erfassung kann insoweit nur die Rede sein, als dass von einem im Grunde stationären Fortbestehen der elektrischen Größen des Wechselspannungsnetzes ausgegangen wird. Insoweit wird vorgeschlagen, basierend auf zuletzt erfassten, insbesondere internen Größen des Verfahrens, die Erfassung ganz oder teilweise ohne Berücksichtigung von Eingangsmessgrößen fortzusetzen. Insoweit erfolgt zumindest eine Schätzung der gewünschten Größen, wobei keine oder nur eine teilweise Anpassung der Schätzgrößen abhängig von Messgrößen erfolgt.

Gemäß einer Ausführungsform wird zudem vorgeschlagen, elektrische Größen des elektrischen Wechselspannungsnetzwerks, insbesondere unter Verwendung eines oben beschriebenen Verfahrens, zu messen und basierend darauf elektrischen Wechselstrom in das Wechselspannungsnetz einzuspeisen, vorzugsweise 3-phasig. Dabei wird das Wechselspannungsnetz auf das Vorliegen wenigstens der Netzstörung des Verlustes der Winkelstabilität und/oder der Netzstörung des Auftretens einer Inselnetzbildung überwacht. Abhängig von der Überwachung, wenn also wenigstens eine der genannten Netzstörungen auftritt, werden Maßnahmen zum Stützen des Wechselspannungsnetzes eingeleitet. Grundsätzlich kommt natürlich auch in Betracht, das Einspeisen je nach Netzstörung zu unterbrechen und den betreffenden Energieerzeuger vom Netz zu trennen.

Vorzugsweise wird zusätzlich zum Überwachen des Verlustes der Winkelstabilität und/oder des Auftretens einer Inselnetzbildung das Auftreten eines 3-phasigen Kurzschlusses und/oder das Auftreten eines 2-poligen Kurzschlusses überwacht wird und Maßnahmen zum Stützen des Wechselspannungsnetzes eingeleitet werden, wenn wenigstens eine der genannten Netzstörungen auftritt.

Eine weitere Ausgestaltung schlägt vor, dass das Verfahren zum Einspeisen elektrischer Energie ein erfindungsgemäßes Verfahren verwendet wird, insbesondere um Frequenz und Phase des Netzes als Basis für die Einspeisung zu bestimmen, als auch um etwaige Netzstörungen zu erkennen, um schnell und zielgerichtet entsprechende Maßnahmen einleiten zu können.

Das Einspeisen in das elektrische Wechselspannungsnetz kann dann in bekannter Weise erfolgen wie beispielsweise unter Verwendung eines 3-phasigen Wechselrichters, der ausgehend von einem Gleichspannungszwischenkreis die drei Phasen durch ein entsprechendes Pulsmuster mit Hilfe von Halbleiterschaltern erzeugt. Die jeweils benötigte Information zu Frequenz und Phase kann hierbei durch das erfindungsgemäße Verfahren bereitgestellt werden.

Beim Überwachen der Netzstörungen wird vorzugsweise ab Auftreten der betreffenden Netzstörung diese innerhalb einer Erfassungszeit von weniger als einer Netzperiode, insbesondere innerhalb einer Erfassungszeit von weniger als einer halben Netzperiode erfasst werden. Ebenso wird vorgeschlagen, Maßnahmen zur Netzstützung ab Auftreten einer Netzstörung innerhalb einer Reaktionszeit von weniger als einer Netzperiode, insbesondere innerhalb einer Reaktionszeit von weniger als einer halben Netzperiode einzuleiten. Um Netzstörungen entsprechend schnell zu erfassen, um in der genannten kurzen Zeit die Netzstörung zu erfassen und auch in der genannten kurzen Zeit Stützmaßnahmen einzuleiten, wird ein wie oben beschriebenes erfindungsgemäßes Verfahren vorgeschlagen, das zur Erfassung nicht auf das Messen von Spannungsnulldurchgängen beschränkt ist, sondern vielmehr unabhängig von den Spannungsnulldurchgängen und mehrfach zwischen Spannungsnulldurchgängen messen kann und entsprechend schnelle Ergebnisse liefern kann.

Außerdem wird eine Messvorrichtung zum Erfassen elektrischer Größen eines 3-phasigen elektrischen Wechselspannungsnetzwerkes vorgeschlagen, die im Wesentlichen ein erfindungsgemäßes Messverfahren umsetzt. Hierzu wird zumindest ein Messmittel zum Messen der elektrischen Momentanspannung jeder der drei Phasen bezogen auf einen Neutralleiter, also zur Messung der Strangspannungen, verwendet. Weiterhin ist eine Recheneinheit zum Bestimmen der Frequenz und Phase des elektrischen Netzwerkes vorgesehen. Die Messmittel liefern, insbesondere digital, die gemessenen Spannungen zu jedem Abtastzeitpunkt an die Recheneinheit. Auf der Recheneinheit sind die Rechenschritte der jeweiligen Ausführungsform des erfindungsgemäßen Messverfahrens implementiert. Insbesondere sind die Rechenschritte auf einem digitalen Signalprozessor zu implementieren, obwohl theoretisch auch die Implementierung mittels eines Analogrechners oder einer analogen Schaltung in Betracht käme.

Außerdem wird eine Einspeisevorrichtung vorgeschlagen, zum Einspeisen elektrischer Energie in ein Wechselspannungsnetzwerk. Die Einspeisevorrichtung weist hierzu zumindest eine Messvorrichtung und eine Einspeiseeinheit auf. Die Messvorrichtung, die insbesondere gemäß einer oben beschriebenen Ausführungsform aufgebaut und ausgeführt ist, erfasst insbesondere Frequenz und Phase des elektrischen Wechselspannungsnetzwerks. Diese Größen bilden die Grundlage für das Einspeisen und sind insbesondere zum Synchronisieren, aber auch zur Erkennung von Störungen vorzusehen. Zum Einspeisen wird eine Einspeiseeinheit verwendet, wobei die Einspeisevorrichtung gemäß einem oben beschriebenen Verfahren zum Einspeisen gesteuert wird. Insbesondere kann eine Einspeiseeinheit einen Frequenzwechselrichter umfassen, um elektrische Energie aus einem Gleichspannungszwischenkreis mittels entsprechender Halbleiterschalter über ein Pulsverfahren in einen sinusförmigen Verlauf je Phase zu wandeln.

Außerdem wird eine Windenergieanlage vorgeschlagen, die insbesondere kinetische Energie dem Wind entnimmt und in elektrische Energie mittels eines Generators umwandelt. Die elektrische Energie wird in ein dreiphasiges Wechselspannungsnetz eingespeist. Zum Einspeisen wird eine wie oben beschriebene Einspeisevorrichtung verwendet. Um die elektrischen Größen, insbesondere Frequenz und Phasen des dreiphasigen Wechselspannungsnetzwerks zu erfassen, wird eine wie oben beschriebene Messvorrichtung vorgeschlagen. Diese und andere erfasste elektrische Größen des Wechselspannungsnetzwerks können der Einspeisevorrichtung als Basis dienen.

Grundsätzlich ist zu beachten, dass die Messvorrichtung Teil der Einspeisevorrichtung sein kann.

Nachfolgend wird die Erfindung beispielhaft anhand von Ausführungsformen unter Bezugnahme auf die begleitenden Figuren näher erläutert.

Fig. 1    zeigt schematisch einen Anschlusspunkt eines 3-phasigen Netzwerks mit Neutralleiter.

Fig. 2    veranschaulicht drei Messwerte eines 3-phasigen Systems in Bezug auf einen Ausschnitt der Spannungsverläufe des 3-phasigen Systems für die Zeitdauer einer Periodenlänge.

Fig. 3    zeigt den grundsätzlichen strukturellen Aufbau eines 3-phasigen Wechselspannungsnetzes mit angeschlossener Messvorrichtung.

Fig. 4    veranschaulicht die Struktur des erfindungsgemäßen Verfahrens gemäß einer Ausführungsform.

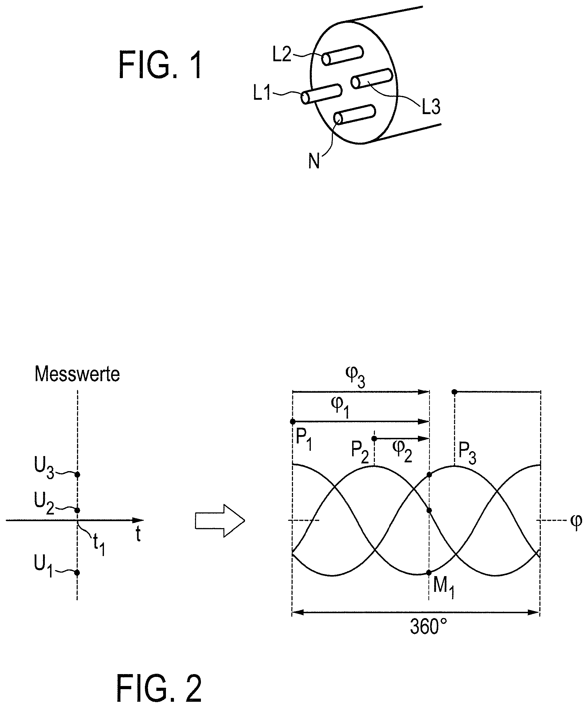

Die Erfindung geht aus von einem 3-phasigen Anschlusspunkt, der drei Leitungen L1, L2 und L3 zum Führen jeweils einer Phase und einen Neutralleiter N aufweist, wie in Fig. 1 dargestellt ist. Zur Veranschaulichung ist der Anschlusspunkt 2 als Kabelende symbolisiert. Ebenso können die drei Phasen L1, L2 und L3 sowie der Neutralleiter N beispielsweise in einer Anschlussbox bereitgestellt werden.

Fig. 2 veranschaulicht die der Erfindung grundsätzlich zugrundeliegende Art der Messung. Demnach wird zu einem Zeitpunkt $t_1$ an jedem der Leiter L1, L2 und L3 eine Spannung gegenüber dem Neutralleiter N gemessen. Diese Messwerte $u_1$, $u_2$ und $u_3$ können grundsätzlich einer Position in einem 360°-Ausschnitt, nämlich einer Periodendauer zugeordnet werden. Hierzu ist in Fig. 2 ein solcher Ausschnitt einer Periodendauer für alle drei Phasen P1, P2 und P3 dargestellt. Die entsprechende Position der Messung zum Zeitpunkt $t_1$ ist in dem Ausschnitt einer Periodendauer, der über einen Winkel $\varphi$ abgetragen ist, der Stelle M1 zugeordnet. Die Phasenwinkel $\varphi_1$, $\varphi_2$ und $\varphi_3$ betreffen somit die Winkel von dem Spannungsmaximum - den Scheitelwert - der jeweiligen Phase zur Meßstelle M1. Die jeweiligen Phasen sind als P1, P2 und P3 gekennzeichnet. Zu der Phase P3 gehört der Phasenwinkel $\varphi_3$. Der Scheitelwert der Phase P3 liegt hinter der Stelle M1 und ist somit veranschaulicht durch einen Pfeil, der im Grunde am Scheitelpunkt von P3 beginnt, bis zum Ende der dargestellten Periode abzumessen ist zuzüglich dem Wert von Anfang der Periode bis zur Meßstelle M1. Bei einem symmetrischen Netz wären die Phasenwinkel $\varphi_1$, $\varphi_2$ und $\varphi_3$ jeweils um 120° oder 240° zueinander verschoben.

Auf die absolute Amplitude der Phasen P1, P2 und P3 kommt es für die Veranschaulichung gemäß Fig. 2 nicht an. Die Amplitude kann beispielsweise für diese Darstellung normiert sein. Die Periodendauer gemäß der Veranschaulichung gemäß Fig. 2 beträgt 360° bzw. $2\pi$.

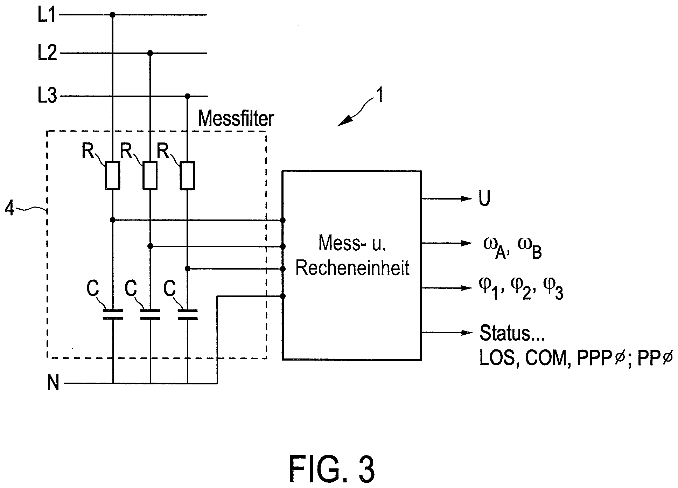

Fig. 3 zeigt einen Gesamtaufbau eines 3-phasigen Netzes mit Neutralleiter und angeschlossener Messvorrichtung 1 gemäß einer Ausführungsform der Erfindung. Zur Messung verwendet die Messvorrichtung 1 einen Messfilter 4, der dazu zwischen den Leitungen L1, L2 und L3 und dem Neutralleiter angeschlossen ist. Die Leitungen L1, L2 und L3 führen entsprechend die erste, zweite bzw. dritte Phase. Zum Messen jeder Strangspannung ist dabei ein RC-Glied zwischen der jeweiligen Leitung L1, L2 bzw. L3 und dem Neutralleiter N angeschlossen. Die so jeweils zwischen dem Widerstand R und dem Kondensator C gemessene Spannung gegen den Nullleiter N wird in die Messvorrichtung 1 eingegeben und dort weiter verarbeitet und ausgewertet.

Die Messvorrichtung 1 gibt hierbei als Ausgangsgrößen bzw. zum Weiterverarbeiten in einer Steuereinheit, insbesondere einer Einspeiseeinheit, die folgenden Größen aus:

-    Eine Schätzung für den Effektivwert U der Wechselspannungen,

-    Schätzungen für die Frequenz der Wechselspannungen (Kreisfrequenzen) $\omega_A$, $\omega_B$,

-    die Winkel $\varphi_1$, $\varphi_2$ und $\varphi_3$ zum Zeitpunkt der Spannungsmessung als aus den Messwerten der Spannung zwischen den Leitern L1, L2 und L3 und dem Neutralleiter N gemessenen Spannungen $u_1$, $u_2$ und $u_3$,

-    Statusinformationen oder Statusflags zu möglichen Netzstörungen des Verlustes der Winkelstabilität LOS (als Loss Of Stability bezeichnet), des Auftretens einer Inselnetzbildung LOM (als Loss Of Mains bezeichnet), des Auftretens eines 3-phasigen Kurzschlusses PPPØ (als Phase-Phase-Phase-Ground bezeichnet) und des Auftretens eines 2-poligen Kurzschlusses PPØ (als Phase-Phase-Ground bezeichnet).

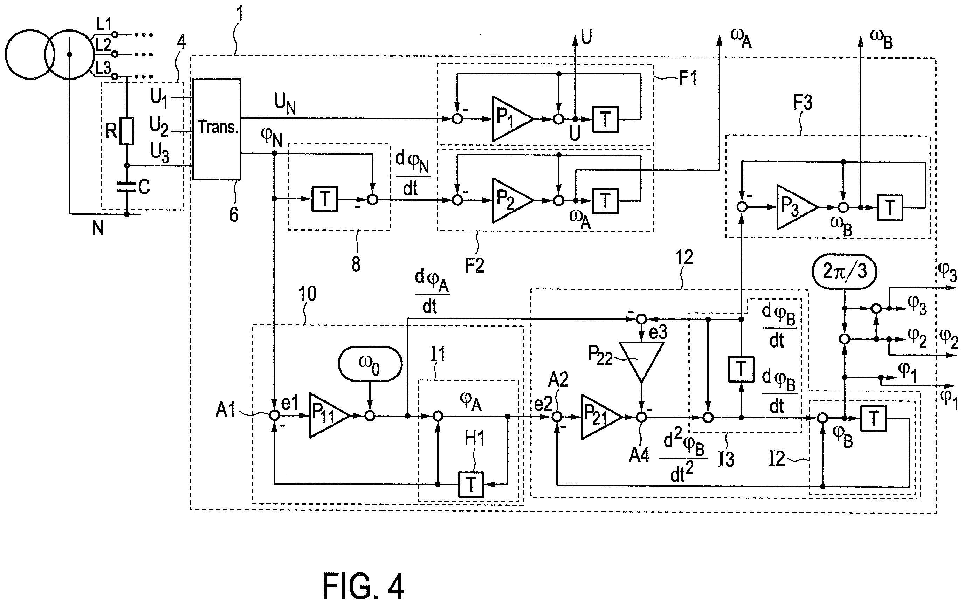

Fig. 4 verdeutlicht den inneren Aufbau der Messvorrichtung 1, die auch als Mess- und Recheneinheit 1 bezeichnet werden kann. Der gezeigte Aufbau ist grundsätzlich als zeitdiskreter Aufbau ausgeführt. Gleichwohl wird der Übersichtlichkeit halber zur Erläuterung teilweise auf zeitkontinuierliche Darstellungen, insbesondere zeitliche Ableitungen, Bezug genommen. Grundsätzlich ist sowohl eine zeitdiskrete als auch eine zeitkontinuierliche Umsetzung möglich.

Die Strangspannungen $u_1$, $u_2$ und $u_3$ werden ständig gemessen und in die Mess- und Recheneinheit eingegeben bzw. liegen dort an. Fig. 4 veranschaulicht den Messfilter 4 nur, indem ein RC-Glied nur für eine Phase ausgeführt ist. Tatsächlich entspricht der Aufbau des Messfilters 4 dem in Fig. 3 gezeigten.

Die jeweiligen Spannungsmesswerte $u_1$, $u_2$ und $u_3$ werden in den Transformationsblock 6 eingegeben. Im Falle eines digitalen Signalprozessors erfolgt dort ein Abtasten und Halten der jeweiligen Messwerte. In dem Transformationsblock 6 erfolgt eine Transformation der drei Spannungswerte $u_1$, $u_2$ und $u_3$ in Polarkoordinaten. Die Transformation wird gemäß der folgenden Gleichungen durchgeführt:

$$\vec{u} = \left[ u_1 + u_2 \exp\left( j\frac{2}{3}\pi \right) + u_3 \exp\left( j\frac{4}{3}\pi \right) \right]$$

$$U_N = \sqrt{\frac{2}{3}}\sqrt{\left(real(\vec{u})\right)^2 + \left(imag(\vec{u})\right)^2}$$

$$\varphi_N = \arctan\left(imag(\vec{u}) / real(\vec{u})\right)$$

Als Zwischenergebnis zur weiteren Verarbeitung und Berechnung wird die Spannung $U_N$ und der Winkel $\varphi_N$ aus dem Transformationsblock 6 ausgegeben.

Die Spannung $U_N$ wird auf ein erstes digitales Filter F1 gegeben, das ein Halteglied T und einen ersten Verstärkungsfaktor $P_1$ aufweist. Der digitale Filter weist zudem zwei Summierstellen auf, die jeweils durch ein Kreissymbol dargestellt sind. Soweit als Vorzeichen ein Minuszeichen angezeigt ist, wird der Wert des betreffenden Signalpfades abgezogen. Ansonsten erfolgt eine Addition, was im Übrigen auch für die weiteren in der Fig. 4 gezeigten Addierglieder gilt.

Die grundsätzliche Funktionsweise eines solchen digitalen Filters F1 ist dem Fachmann grundsätzlich bekannt und es wird daher nicht weiter darauf eingegangen. In dem ersten digitalen Filter F1 wird somit die Spannung $U_N$ gefiltert und die Spannung U als Schätzung für den Effektivwert U der Wechselspannungen ausgegeben.

Der Phasenwinkel $\varphi_N$ wird in einem Differenzierglied 8 zeitdiskret abgeleitet und entspricht damit einer Winkelfrequenz, die in der Fig. 4 als $d\varphi_N/dt$ eingetragen ist. Diese Winkelfrequenz bzw. Kreisfrequenz wird auf ein zweites digitales Filter F2 gegeben, das im Aufbau dem ersten digitalen Filter F1 entspricht und einen zweiten Verstärkungsfaktor P2 aufweist. Als Ergebnis ergibt sich eine Schätzung für die Frequenz der Wechselspannung $\omega_A$, die entsprechend als eine Schätzung für die Frequenz der Wechselspannung $\omega_A$ ausgegeben wird.

Der Phasenwinkel $\varphi_N$ wird zudem in einen Frequenzregelkreis 10 eingegeben. In dem Frequenzregelkreis 10 wird eine erste Hilfsfrequenz $d\varphi_A/dt$ bestimmt und im Sinne einer Regelung der Netzfrequenz bzw. Netzkreisfrequenz nachgeführt, soweit der Frequenzregelkreis 10 im Wesentlichen interpretiert werden kann. In dem Frequenzregelkreis 10 ist ein erstes zeitdiskretes Integrierglied I1 vorhanden, das aus der ersten Hilfsfrequenz $d\varphi_A/dt$ einen ersten Hilfswinkel $\varphi_A$ bestimmt. An der ersten Additionsstelle A1 wird von dem aktuellen Phasenwinkel $\varphi_N$ der um eine Abtastperiode zurückliegende erste Hilfswinkel $\varphi_A$ abgezogen. Hierdurch ergibt sich eine erste Differenzeingangsgröße e1, die dem Grunde nach eine Differenzfrequenz ist. Diese erste Differenzeingangsgröße e1 kann im weiteren Sinne als Regelfehler oder Regelabweichung des Frequenzregelkreises 10 interpretiert werden, soweit eine Interpretation überhaupt möglich ist. Jedenfalls wird diese erste Differenzeingangsgröße e1 mit einer Regelverstärkung P11 multipliziert und zur Nennfrequenz $\omega0$ addiert, um die erste Hilfsfrequenz $d\varphi_A/dt$ zu bestimmen.

Grundsätzlich ist noch anzumerken, dass ein digitales Integrierglied wie das digitale Integrierglied I1 zum Aufintegrieren einer Frequenz zu einem Winkel bei angenommener positiver Frequenz zu einem ständig ansteigenden Winkel führt, der im Grunde gegen unendlich strebt. Grundsätzlich ist natürlich der Wert eines Winkels zwischen 0° und 360° bzw. 0 und $2\pi$ von Interesse und bei der Umsetzung kann jeweils beim Überschreiten des Wertes 360° oder Unterschreiten von 0 eine Zurücksetzung um den Wert 360 erfolgen, was hier nicht im Detail ausgeführt ist.

Obwohl der Frequenzregelkreis 10 aufgrund der Regelverstärkung P11 als P-Regler aufgefasst werden kann, ist doch für die erste Hilfsfrequenz $d\varphi_A/dt$ stationäre Genauigkeit ohne Regelabweichung erzielbar, was in dem integralen Verhalten bei der Bestimmung des ersten Hilfswinkels $\varphi_A$ durch das erste Integrierglied I1 begründet ist.

Die erste Hilfsfrequenz $d\varphi_A/dt$ könnte als Schätzung für die Frequenz der Wechselspannung verwendet und entsprechend durch die Messvorrichtung 1 ausgegeben werden. Gemäß der in Fig. 4 dargestellten Form ist aber eine weitere Verarbeitung, insbesondere Verbesserung, vorgesehen.

In einem zweiten Regelkreis 12 wird eine zweite Hilfsfrequenz $d\varphi_B/dt$ bestimmt. Mittels eines zweiten Integriergliedes I2 wird der zweite Hilfswinkel $\varphi_B$ bestimmt. An der zweiten Addierstelle A2 wird von dem ersten Hilfswinkel $\varphi_A$ der zweite um eine Abtastzeit bzw. Abtastperiode verzögerte zweite Hilfswinkel $\varphi_B$ abgezogen und es ergibt sich eine zweite Differenzeingangsgröße e2. Diese zweite Differenzeingangsgröße ist dem Grunde nach eine Differenzfrequenz. Sie kann im weiteren Sinne als Regelfehler interpretiert erden um die zweite Hilfsfrequenz $d\varphi_B/dt$ auf die erste Hilfsfrequenz auszuregeln bzw. dieser nachzuführen.

Es ist zu beachten, dass die Interpretationen als Regelung zur veranschaulichenden Erläuterung dienen sollen. Eine klassische Regelung im Sinne eines Soll-Ist-Wert-Vergleiches findet insofern nicht statt. Vielmehr gilt es, Schätzwerte in ihren Werten oder auch ihrer Dynamik zu verbessern.

Jedenfalls wird die zweite Differenzeingangsgröße e2 über eine zweite Regelverstärkung P21 geführt bzw.

damit multipliziert. Außerdem erfolgt eine Differenzbildung zwischen der um eine Abtastzeit zurückliegenden zweiten Hilfsfrequenz $d\varphi_B/dt$ und der aktuellen ersten Hilfsfrequenz $d\varphi_A/dt$ an der dritten Additionsstelle. Es ergibt sich eine dritte Differenzeingangsgröße e3, die dem Grunde nach eine Differenzwinkelbeschleunigung ist. Multipliziert mit der dritten Regelverstärkung P22 wird sie von der mit der zweiten Regelverstärkung P21 multiplizierten zweiten Differenzeingangsgröße e2 an der vierten Additionsstelle A4 abgezogen. Es ergibt sich eine Winkelbeschleunigung $\dfrac{d^2\varphi_B}{dt^2}$. Mittels eines dritten Integriergliedes I3 ist schließlich die zweite Hilfsfrequenz $d\varphi_B/dt$ bestimmbar. Es ist zu bemerken, dass durch die Aufschaltung der dritten Differenzeingangsgröße e3 unter Berücksichtigung der dritten Regelverstärkung P22 an der vierten Addierstelle A4 eine Dämpfungswirkung erzielbar ist. Der zweite Regelkreis 12 ist somit im Wesentlichen dazu vorgesehen, Einfluss auf das dynamische Verhalten der Frequenzschätzung zu nehmen.

Die zweite Hilfsfrequenz $d\varphi_B/dt$ wird schließlich über ein drittes digitales Filter F3 geführt und der Schätzwert für die Frequenz der Wechselspannung $\omega_B$ wird ausgegeben. Außerdem kann der zweite Hilfswinkel $\varphi_B$ unmittelbar als Schätzwert für den ersten Phasenwinkel $\varphi 1$ ausgegeben werden und jeweils der Schätzwert für den zweiten Phasenwinkel $\varphi 2$ und den dritten Phasenwinkel $\varphi_3$ können durch Addition von $2\pi/3$ bzw. $4\pi/3$ (120° bzw. 240°) ermittelt und ausgegeben werden.

Das mit Hilfe der Fig. 4 veranschaulichte Verfahren kann auch durch das folgende Gleichungssystem angegeben werden:

$$\frac{dU}{dt} = P_1\left(U_N - U\right)$$

$$\frac{d\omega_A}{dt} = P_2\left(\frac{d\varphi_N}{dt} - \omega_A\right)$$

$$\frac{d\omega_B}{dt} = P_3\left(\frac{d\varphi_B}{dt} - \omega_B\right)$$

$$\frac{d\varphi_A}{dt} = P_{11}\left(\varphi_N - \varphi_A\right) + \omega_O$$

$$\frac{d\varphi_B}{dt} = \omega_B$$

$$\frac{d\omega_B}{dt} = P_{21}\left(\varphi_A - \varphi_B\right) + P_{22}\left(\frac{d\varphi_A}{dt} - \frac{d\varphi_B}{dt}\right)$$

$$\varphi_1 = \varphi_A,\ \varphi_2 = \varphi_1 + \frac{2}{3}\pi,\ \varphi_3 = \varphi_2 + \frac{2}{3}\pi$$

Durch die Umsetzung der Messung jedenfalls gemäß der Ausführungsform nach Fig. 4 können auf vorteilhafte Weise - jedenfalls für einen Übergangszeitraum - im Fehlerfall weiterhin Schätzgrößen geliefert werden. Erfolgt beispielsweise eine Unterbrechung der Messvorrichtung 1 oder des Messfilters 4 zum Wechselspannungsnetz, so stehen keine Messgrößen zur Verbesserung der Schätzung zur Verfügung. Vielmehr kann davon ausgegangen werden, dass etwaige dem Grunde nach unsinnige Messwerte die Schätzung verschlechtern oder sogar unbrauchbar machen. Ein solcher Fehlerfall kann beispielsweise erkannt werden, wenn der Phasenwinkel $\varphi_N$ sich plötzlich nicht mehr ändert oder in seinem Wert springt. Ebenso kann ein plötzliches Einbrechen der Spannungsamplitude $U_N$ ein Indiz sein. In einem solchen Fall ist zumindest der Signalanschluss unmittelbar hinter der Regelverstärkung P11 zu kappen. Dies kann natürlich auch dadurch erfolgen, dass die Regelverstärkung P11 auf Null gesetzt wird. Da die Erfassung eines Fehlerfalls möglicherweise erst durch Beobachtung der ersten Hilfsfrequenz $d\varphi_A/dt$ erfolgt, kann der erste Phasenwinkel $\varphi_A$ bereits grob falsch sein. Für diesen Fall empfiehlt es sich, beispielsweise in dem ersten Halteglied H1 den Wert für den ersten Hilfsphasenwinkel $\varphi_A$ zu korrigieren, beispielsweise basierend auf einem um wenigstens eine Abtastzeit weiter zurückliegenden Wert. Insoweit kann die Schätzung, insbesondere die zweite Schätzung der Frequenz der Wechselspannung $\omega_B$ und die Schätzung der Phasenwinkel $\varphi_1$, $\varphi_2$ und $\varphi_3$ fortgesetzt werden und zumindest für einen kurzen Zeitraum von beispielsweise einigen Netzperioden noch brauchbare Werte liefern. Natürlich können weitere, insbesondere plötzliche Änderungen in der Frequenz und der Phase des Wechselspannungsnetzes ohne Messung nicht mehr zuverlässig erkannt werden. Ist der Fehlerfall beendet, kann in normaler Weise weiter gemessen werden. Insbesondere kann der Signalanschluss hinter der Regalverstärkung P11 wieder verbunden werden.

**Patentansprüche**

1. Verfahren zum Erfassen elektrischer Größen eines dreiphasigen Wechselspannungsnetzes mit einer ersten, zweiten und dritten Phase (L1, L2, L3) umfassend die Schritte:

   - Messen jeweils eines Spannungswertes ($u_1$, $u_2$, $u_3$) der ersten, zweiten und dritten Phasen (L1, L2, L3) in Bezug auf einen Neutralleiter (N) zu einem ersten Zeitpunkt ($t_1$),
   - Transformieren der drei Spannungswerte $u_1$, $u_2$, $u_3$ des ersten Zeitpunktes ($t_1$) in Polarkoordinaten mit einer Spannungsamplitude $U_N$ und einem Phasenwinkel $\varphi_N$, so dass eine Transformation der zum ersten Zeitpunkt gemessenen Spannungswerte $u_1$, $u_2$, $u_3$ in Polarkoordinaten $U_N$, $\varphi_N$ in eine komplexwertige Größe erfolgt, gemäß der Gleichung:

$$\vec{u} = \left[ u_1 + u_2 \exp\left( j\frac{2}{3}\pi \right) + u_3 \exp\left( j\frac{4}{3}\pi \right) \right],$$

   so dass dabei entsprechend ein Betrag und ein Phasenwinkel entsteht,
   - Wiederholen des Messens und Transformierens für wenigstens einen weiteren Zeitpunkt und
   - Bestimmen der aktuellen Frequenz und einer gefilterten Spannungsamplitude (U) aus den in Polarkoordinaten $U_N$, $\varphi_N$ transformierten Spannungswerten, wobei die aktuelle Frequenz ($\omega_A$) und die gefilterte Spannungsamplitude (U) ausgegeben werden, wobei
   - in einem digitalen Filter (F1) die Spannungsamplitude ($U_N$) gefiltert und die gefilterte Spannung als Schätzung für den Effektivwert U der Wechselspannungen ausgegeben wird, wobei
   - das digitale Filter ein Halteglied (T), ein Verstärkungsfaktor (P1) und eine erste und eine zweite Summierstelle aufweist, und
   - an der ersten Summierstelle eine Differenz gebildet wird, aus der Spannungsamplitude ($U_N$) und der über das Haltglied (T) gegebenen gefilterten Spannung, und die Differenz mit dem Verstärkungsfaktor multipliziert wird, und an der zweiten Summierstelle zu der über das Haltglied gegebenen gefilterten Spannung addiert wird, um die auszugebende gefilterte Spannung zu bilden.

2. Verfahren nach
   Anspruch 1, **dadurch gekennzeichnet, dass** zur Erfassung der Frequenz eine Frequenzregelung verwendet wird, die eine erste Hilfsfrequenz ($d\varphi_A/dt$) ausregelt.

3. Verfahren nach Anspruch 2, **dadurch gekennzeichnet, dass** zur Frequenzregelung ein erster Differenzwinkel gebildet wird zwischen

   - dem bei der Transformation gebildeten Phasenwinkel ($\varphi_N$) und
   - einem ersten um eine Abtastzeit zurückliegenden Hilfsphasenwinkel ($\varphi_A$), dieser erste Differenzwinkel wird mit einem ersten Verstärkungsfaktor ($P_{11}$) multipliziert und/oder zu einem Anfangsfrequenzwert (wo) addiert, um die erste Hilfsfrequenz ($d\varphi_A/dt$) zu erhalten, und der erste Hilfsphasenwinkel ($\varphi_A$) wird aus der ersten Hilfsfrequenz ($d\varphi_A/dt$) bestimmt.

4. Verfahren nach einem der vorstehenden Ansprüche, **dadurch gekennzeichnet, dass** zur Verbesserung der Frequenzbestimmung ein zweiter Hilfsphasenwinkel ($d\varphi_B$) mit einer zweiten Hilfsfrequenz ($d\varphi_B/dt$) bestimmt wird.

5. Verfahren nach Anspruch 4, **dadurch gekennzeichnet, dass**

   - ein zweiter Differenzwinkel gebildet wird als Differenz zwischen dem ersten Hilfsphasenwinkel ($\varphi_A$) und dem zweiten um eine Abtastzeit zurückliegenden Hilfsphasenwinkel ($\varphi_B$),
   - eine Hilfsdifferenzfrequenz gebildet wird als Differenz zwischen der zweiten Hilfsfrequenz ($d\varphi_B/dt$) und der ersten Hilfsfrequenz ($d\varphi_A/dt$) und
   - eine Hilfswinkelbeschleunigung aus dem zweiten Differenzwinkel und der Hilfsdifferenzfrequenz gebildet wird, wobei die Hilfswinkelbeschleunigung repräsentativ ist für eine zweite Ableitung des zweiten Hilfsphasenwinkels nach der Zeit, wobei der zweite Hilfsphasenwinkel ($\varphi_B$) und die zweite Hilfsfrequenz ($d\varphi_A/dt$) aus der Hilfswinkelbeschleunigung berechnet wird.

6. Verfahren nach Anspruch 5, **dadurch gekennzeichnet, dass** die Hilfswinkelbeschleunigung als Differenz gebildet wird zwischen

   - dem zweiten Differenzwinkel oder dem mit einem zweiten Verstärkungsfaktor ($P_{21}$) multiplizierten zweiten Differenzwinkel und
   - der Hilfsdifferenzfrequenz oder der mit einem dritten Verstärkungsfaktor ($P_{22}$) multiplizierten Hilfsdifferenzfrequenz.

7. Verfahren nach einem der vorstehenden Ansprüche, **dadurch gekennzeichnet, dass**

   - der bei der Transformation erhaltene Phasenwinkel ($\varphi_1$, $\varphi_2$, $\varphi_3$) nach der Zeit differenziert und als erfasste Frequenz oder als erfasste Vergleichsfrequenz ausgegeben wird,
   - die zweite Hilfsfrequenz ($d\varphi_A/dt$) als erfasste Frequenz ausgegeben wird und/oder
   - der zweite Hilfsphasenwinkel ($\varphi_B$) als erfasster Phasenwinkel ($\varphi_N$) einer Phase ausgegeben wird,

   wobei vorzugsweise eine oder mehrere der auszugebenden Größen vorm Ausgeben gefiltert werden.

8. Verfahren nach einem der vorstehenden Ansprüche, weiter umfassend den Schritt Überwachen des Wechselspannungsnetzes auf das Vorliegen wenigstens einer Netzstörung aus der Liste:

   - Verlust der Winkelstabilität,
   - Auftreten einer Inselnetzbildung,
   - Auftreten eines 3-phasigen Kurzschlusses und
   - Auftreten eines 2-poligen Kurzschlusses,

   und/oder Bereitstellen eines Signales zum Anzeigen des Vorliegens einer der Netzstörungen.

9. Verfahren nach einem der vorstehenden Ansprüche, **dadurch gekennzeichnet, dass** die Messung bzw. Erfassung auf eine Meßstörung beobachtet wird und beim Auftreten einer Meßstörung eine Erfassung als Schätzung basierend auf zuletzt verwendeten Größen fortgesetzt wird.

10. Verfahren zum Einspeisen elektrischer Energie in ein elektrisches Wechselspannungsnetz umfassend die Schritte

   - Erfassen elektrischer Größen des elektrischen Wechselspannungsnetzwerks, wobei das Erfassen durch ein Verfahren nach einem der Ansprüche 1 bis 9 erfolgt,
   - Einspeisen elektrischen Wechselstroms in das Wechselspannungsnetz,
   - Überwachen des Wechselspannungsnetzes auf das Vorliegen wenigstens einer Netzstörung aus der Liste:
   - Verlust der Winkelstabilität und
   - Auftreten einer Inselnetzbildung, und
   - Einleiten von Maßnahmen zum Stützen des Wechselspannungsnetzes, wenn wenigstens eine der genannten Netzstörungen auftritt.

11. Verfahren nach Anspruch 10, **dadurch gekennzeichnet, dass** zusätzlich das Wechselspannungsnetz auf das Vorliegen wenigstens weiterer Netzstörung aus der Liste

   - Auftreten eines 3-phasigen Kurzschlusses und
   - Auftreten eines 2-poligen Kurzschlusses

überwacht wird und Maßnahmen zum Stützen des Wechselspannungsnetzes eingeleitet werden, wenn wenigstens eine der genannten Netzstörungen auftritt.

**12.** Verfahren nach Anspruch 10 oder 11, **dadurch gekennzeichnet, dass** das Erfassen der elektrischen Größen durch ein Verfahren nach einem der Ansprüche 1 bis 9 erfolgt und/oder dass die Netzstörungen ab Auftreten der betreffenden Netzstörung innerhalb einer Erfassungszeit von weniger als einer Netzperiode erfasst werden, insbesondere innerhalb einer Erfassungszeit von weniger als einer halben Netzperiode, und/oder dass Maßnahmen zur Netzstützung ab Auftreten der Netzstörung innerhalb einer Reaktionszeit von weniger als einer Netzperiode eingeleitet werden, insbesondere innerhalb einer Reaktionszeit von weniger als einer halben Netzperiode.

**13.** Messvorrichtung zum Erfassen elektrischer Größen eines 3-phasigen elektrischen Wechselspannungsnetzwerks, nämlich wenigstens der Frequenz und einer Phase des Wechselspannungsnetzwerks umfassend:

- Spannungsmessmittel zum Messen der elektrischen Momentanspannung jeder der drei Phasen (L1, L2, L3) bezogen auf einen Neutralleiter (N),
- eine Recheneinheit (1) zum Bestimmen wenigstens der Frequenz und Phase des elektrischen Netzwerkes,

wobei die Messvorrichtung ein Verfahren nach einem der Ansprüche 1 bis 8 verwendet, bzw. dazu vorbereitet ist, ein solches Messverfahren zu verwenden.

**14.** Einspeisevorrichtung zum Einspeisen elektrischer Energie in ein Wechselspannungsnetzwerk, umfassend,

- eine Messvorrichtung, insbesondere nach Anspruch 13, zum Messen elektrischer Größen des Wechselspannungsnetzwerkes und
- eine Einspeiseeinheit zum Einspeisen elektrischer Energie in das Wechselspanungsnetzwerk,

wobei die Einspeisevorrichtung ein Verfahren nach einem der Ansprüche 9 - 11 verwendet, bzw. dazu vorbereitet ist, ein solches Verfahren zu verwenden.

**15.** Windenergieanlage zum Wandeln von Windenergie in elektrische Energie und zum Einspeisen der elektrischen Energie in ein Wechselspannungsnetz umfassend eine Messvorrichtung nach Anspruch 13 und/oder eine Einspeisevorrichtung nach Anspruch 14.

**Claims**

**1.** A method of detecting electric variables of a three-phase AC network having a first, a second and a third phase (L1, L2, L3), including the steps:

- measuring a respective voltage value ($u_1$, $u_2$, $u_3$) of the first, second and third phases (L1, L2, L3) in relation to a neutral conductor (N) at a first moment in time ($t_1$),
- transforming the three voltage values $u_1$, $u_2$, $u_3$ of the first moment in time ($t_1$) into polar co-ordinates with a voltage amplitude ($U_N$) and a phase angle $\varphi_N$ so that transformation of the voltage values $u_1$, $u_2$, $u_3$ measured at the first moment in time in polar co-ordinates $U_N$, $\varphi_N$ into a complex-value variable is effected in accordance with the equation:

$$\vec{u} = \left[ u_1 + u_2 \exp\left( j\frac{2}{3}\pi \right) + u_3 \exp\left( j\frac{4}{3}\pi \right) \right]$$

so that an amount and a phase angle correspondingly occur in that case,
- repeating measurement and transformation for at least one further moment in time, and
- determining the currently prevailing frequency and the filtered voltage amplitude (U) from the voltage values transformed into polar co-ordinates $U_N$, $\varphi_N$ wherein the currently frequency ($\omega_A$) and the filtered voltage amplitude (U) are output, wherein
- in a digital filter (F1) the voltage amplitude (Un) is filtered and the filtered voltage is output as an estimate for the effective value U of the AC voltages, wherein

- the digital filter comprises a holding member (T), a amplification factor (P1) and a first and a second summing point, and

- at the first summing point, a difference is formed from the voltage amplitude (Un) and the filtered voltage given by the holding element (T), and the difference is multiplied by the amplification factor, and at the second summing point, the difference is added to the filtered voltage given by the holding element to form the filtered voltage to be output.

2. A method according to claim 1 **characterised in that** that for the determination of the frequency a frequency control is used, which controls a first auxiliary frequency ($d\varphi_A/dt$).

3. A method according to claim 2 **characterised in that** for frequency control a first difference angle is formed between

- the phase angle formed in the transformation operation ($\varphi_N$) and
- a first auxiliary phase angle ($\varphi_A$) which is back by a sampling time, the first difference angle is multiplied by a first amplification factor ($P_{11}$) and/or added to an initial frequency value ($\omega_0$) to obtain the first auxiliary frequency ($d\varphi_A/dt$), and the first auxiliary phase angle ($\varphi_A$) is determined from the first auxiliary frequency ($d\varphi_A/dt$).

4. A method according to one of the preceding claims, **characterized in that** in order to improve the frequency determination a second auxiliary phase angle ($d\varphi_B/dt$) with a second auxiliary frequency ($d\varphi_B$) is determined.

5. A method according to claim 4, **characterized in that**

- a second difference angle is formed as the difference between the first auxiliary phase angle ($\varphi_A$) and the second auxiliary phase angle ($\varphi_B$) which is back by a sampling time,
- an auxiliary difference frequency is formed as the difference between the second auxiliary frequency ($d\varphi_B/dt$) and the first auxiliary frequency ($d\varphi_A/dt$), and
- an auxiliary angle acceleration is formed from the first difference angle and the auxiliary difference frequency, wherein the auxiliary angle acceleration is representative of a second derivative of the second auxiliary phase angle in respect of time, wherein the second auxiliary phase angle ($\varphi_B$) and the second auxiliary frequency ($d\varphi_B/dt$) is calculated from the auxiliary angle acceleration.

6. A method according to claim 5, **characterised in that** the auxiliary angle acceleration is formed as the difference between- the second difference angle or the second difference angle multiplied by a second amplification factor ($P_{21}$), and

- the auxiliary difference frequency or the auxiliary difference frequency multiplied by a third amplification factor ($P_{22}$).

7. A method according to one of the preceding claims, **characterized in that**

- the phase angle ($\varphi_1$, $\varphi_2$, $\varphi_3$) obtained during the transformation is differentiated according to the time and is output as the detected frequency or as the detected comparison frequency is output,
- the second auxiliary frequency ($d\varphi_A/dt$) is output as detected frequency and/or
- the second auxiliary phase angle (cps) is output as detected phase angle ($\varphi_N$) of a phase is output,

wherein preferably one or more of the quantities to be output are filtered before outputting.

8. A method according to one of the preceding claims and further including the step of monitoring the AC network for the existence of at least one network disturbance from the list:

- loss of angle stability,
- occurrence of loss of mains,
- occurrence of a three-phase short-circuit, and
- occurrence of a two-pole short-circuit
- and/or providing a signal for indicating the existence of one of the network disturbances.

9. A method according to one of the preceding claims **characterised in that** measurement or detection is observed for a measurement disturbance and when a measurement disturbance occurs a detection operation is continued as an estimate based on variables last used.

10. A method of feeding electric energy into an electric AC network including the steps:

   - detecting electric variables of the electric AC network, wherein detection is effected according to one of claims 1 to 9,
   - feeding electric alternating current into the AC network,
   - monitoring the AC network for the existence of at least one network disturbance from the list:

      - loss of angle stability, and
      - occurrence of loss of mains, and
      - initiating measures for supporting the AC network if at least one of said network disturbances occurs.

11. A method according to claim 10 **characterised in that** in addition the AC network is monitored for the existence of at least one further network disturbance from the list:

      - occurrence of a three-phase short-circuit, and
      - occurrence of a two-pole short-circuit,

   and actions are initiated for supporting the AC network if at least one of said network disturbances occurs.

12. A method according to claim 10 or claim 11 **characterised in that** the electrical variables are detected by a method according to one of claims 1 to 9 and/or that the network disturbances are detected as from the occurrence of the network disturbance in question within a detection time of less than a network period, in particular within a detection time of less than half a network period, and/or measures are initiated for network support as from the occurrence of the network disturbance within a reaction time of less than a network period, in particular within a reaction time of less than half a network period.

13. A measuring device for detecting electric variables of a three-phase electric AC network, namely at least the frequency and a phase of the AC network, including:

      - voltage measuring means for measuring the electric instantaneous voltage of each of the three phases (L1, L2, L3) in relation to a neutral conductor (N), and
      - a computing unit (1) for determining at least the frequency and phase of the electric network,

   wherein the measuring device uses a method according to one of claims 1 to 8 or is adapted to use such a measuring method.

14. A feed-in device for feeding electric energy into an AC network including

      - a measuring device, in particular according to claim 13, for measuring electric variables of the AC network, and
      - a feed-in unit for feeding electric energy into the AC network,

   wherein the feed-in device uses a method according to one of claims 9 to 11 or is adapted to use such a method.

15. A wind power installation for converting wind energy into electric energy and for feeding the electric energy into an AC network including a measuring device according to claim 13 and/or a feed-in device according to claim 14.

**Revendications**

1. Procédé de détection de grandeurs électriques d'un réseau triphasé de tensions alternatives ayant des première, deuxième et troisième phases (L1, L2, L3), comportant les étapes consistant à :

      - mesurer respectivement une valeur de tension ($u_1$, $u_2$, $u_3$) des première, deuxième et troisième phases (L1, L2, L3) par rapport à un conducteur neutre (N) à un premier instant ($t_1$),
      - transformer les trois valeurs de tension $u_1$, $u_2$, $u_3$ du premier instant ($t_1$) dans des coordonnées polaires avec une amplitude de tension $U_N$ et un angle de phase $\varphi_N$ de sorte qu'une transformation des valeurs de tension $u_1$, $u_2$, $u_3$ mesurées au premier instant dans des coordonnées polaires $U_N$, $\varphi_N$ résulte en une grandeur de valeur complexe, selon l'équation :

$$\vec{u} = \left[ u_1 + u_2 \exp\left( j\frac{2}{3}\pi \right) + u_3 \exp\left( j\frac{4}{3}\pi \right) \right],$$

de sorte que se forment de manière correspondante un module et un angle de phase,
- répéter la mesure et la transformation pour au moins un autre instant et
- déterminer la fréquence actuelle et une amplitude de tension filtrée (U) à partir des valeurs de tension transformées dans des coordonnées polaires $U_N$, $\varphi_N$, dans lequel la fréquence actuelle ($\omega_A$) et l'amplitude de tension filtrée (U) sont sorties, dans lequel
- dans un filtre numérique (F1), l'amplitude de tension ($U_N$) est filtrée et la tension filtrée est sortie en tant qu'estimation de la valeur efficace U des tensions alternatives, dans lequel le filtre numérique comprend un élément de blocage (T), un facteur d'amplification (P1) et un premier et un second point de sommation, et
- au premier point de sommation est formée une différence à partir de l'amplitude de tension ($U_N$) et de la tension filtrée donnée par le biais de l'élément de blocage (T), et la différence est multipliée par le facteur d'amplification et, au second point de sommation, est additionnée à la tension filtrée donnée par l'élément de blocage pour former la tension filtrée à sortir.

2. Procédé selon la revendication 1, **caractérisé en ce que** pour la détection de la fréquence est employée une régulation de fréquence qui règle parfaitement une première fréquence auxiliaire ($d\varphi_A/dt$).

3. Procédé selon la revendication 2, **caractérisé en ce que** pour la régulation de fréquence est formé un premier angle de différence entre

- l'angle de phase ($\varphi_N$) formé lors de la transformation et
- un premier angle de phase auxiliaire ($\varphi_A$) situé en aval d'un temps de balayage,

ce premier angle de différence est multiplié par un premier facteur d'amplification ($P_{11}$) et/ou additionné à une valeur de fréquence initiale ($\omega_0$) pour obtenir la première fréquence auxiliaire ($d\varphi_A/dt$), et le premier angle de phase auxiliaire ($\varphi A$) est déterminé à partir de la première fréquence auxiliaire ($d\varphi_A/dt$) .

4. Procédé selon l'une quelconque des revendications précédentes, **caractérisé en ce que** pour améliorer la détermination de fréquence est déterminé un second angle de phase auxiliaire ($d\varphi_B$) avec une seconde fréquence auxiliaire ($d\varphi_B/dt$) .

5. Procédé selon la revendication 4, **caractérisé en ce que**

- un second angle de différence est formé en tant que différence entre le premier angle de phase auxiliaire ($\varphi_A$) et le second angle de phase auxiliaire ($\varphi_B$) situé en aval d'un temps de balayage,
- une fréquence de différence auxiliaire est formée en tant que différence entre la seconde fréquence auxiliaire ($d\varphi_B/dt$) et la première fréquence auxiliaire ($d\varphi_A/dt$) et
- une accélération angulaire auxiliaire est formée à partir du second angle de différence et de la fréquence de différence auxiliaire, dans lequel l'accélération angulaire auxiliaire est représentative d'une dérivée seconde par rapport au temps du second angle de phase auxiliaire, dans lequel le second angle de phase auxiliaire ($\varphi_B$) et la seconde fréquence auxiliaire ($d\varphi_A/dt$) sont calculés à partir de l'accélération angulaire auxiliaire.

6. Procédé selon la revendication 5, **caractérisé en ce que** l'accélération angulaire auxiliaire est formée en tant que différence entre

- le second angle de différence ou le second angle de différence multiplié par un deuxième facteur d'amplification ($P_{21}$) et
- la fréquence de différence auxiliaire ou la fréquence de différence auxiliaire multipliée par un troisième facteur d'amplification ($P_{22}$) .

7. Procédé selon l'une quelconque des revendications précédentes, **caractérisé en ce que**

- l'angle de phase ($\varphi_1$, $\varphi_2$, $\varphi_3$) obtenu lors de la transformation est différencié selon le temps et sorti en tant que fréquence détectée ou en tant que fréquence de référence détectée,
- la seconde fréquence auxiliaire ($d\varphi_A/dt$) est sortie en tant que fréquence détectée et/ou
- le second angle de phase auxiliaire ($\varphi_B$) est sorti en tant qu'angle de phase ($\varphi_N$) détecté d'une phase,

dans lequel de préférence une ou plusieurs des grandeurs à sortir sont filtrées avant leur sortie.

**8.** Procédé selon l'une quelconque des revendications précédentes, comprenant en outre l'étape consistant à surveiller dans le réseau de tensions alternatives la présence d'au moins une perturbation de réseau dans la liste :

- perte de la stabilité angulaire,
- survenance de la formation d'un réseau autonome,
- survenance d'un court-circuit triphasé et
- survenance d'un court-circuit entre deux pôles,

et/ou fournir un signal pour afficher la présence d'une des perturbations de réseau.

**9.** Procédé selon l'une quelconque des revendications précédentes, **caractérisé en ce que** la mesure ou la détection est observée sur une perturbation de mesure et que, lors de la survenance d'une perturbation de mesure, une détection est poursuivie en tant qu'estimation basée sur des grandeurs employées en dernier.

**10.** Procédé d'injection d'énergie électrique dans un réseau électrique de tensions alternatives comportant les étapes consistant à :

- détecter des grandeurs électriques du réseau électrique de tensions alternatives, dans lequel la détection étant effectuée par un procédé selon l'une quelconque des revendications 1 à 9,
- injecter un courant alternatif électrique dans le réseau de tensions alternatives,
- surveiller dans le réseau de tensions alternatives la présence d'au moins une perturbation de réseau dans la liste :
- perte de la stabilité angulaire et
- survenance de la formation d'un réseau autonome, et
- déclencher des mesures pour soutenir le réseau de tensions alternatives, lorsqu'au moins une des perturbations de réseau mentionnées survient.

**11.** Procédé selon la revendication 10, **caractérisé en ce que**, en plus, le réseau de tensions alternatives est surveillé quant à la présence d'au moins une autre perturbation de réseau dans la liste :

- survenance d'un court-circuit triphasé et
- survenance d'un court-circuit entre deux pôles,

et que des mesures pour soutenir le réseau de tensions alternatives sont déclenchées lorsqu'au moins une des perturbations de réseau mentionnée survient.

**12.** Procédé selon la revendication 10 ou 11, **caractérisé en ce que** la détection des grandeurs électriques est effectuée par un procédé selon l'une quelconque des revendications 1 à 9 et/ou que les perturbations de réseau sont détectées à partir de la survenance d'une perturbation de réseau concernée au cours d'un temps de détection de moins d'une période de réseau, en particulier au cours d'un temps de détection de moins d'une demi-période de réseau, et/ou que des mesures de soutien de réseau sont déclenchées à partir de la survenance de la perturbation de réseau au cours d'un temps de réaction de moins d'une période de réseau, en particulier au cours d'un temps de réaction de moins d'une demi-période de réseau.

**13.** Dispositif de mesure pour détecter des grandeurs électriques d'un réseau électrique triphasé de tensions alternatives, à savoir au moins la fréquence et une phase du réseau de tensions alternatives, comportant :

- un moyen de mesure de tension pour mesurer la tension électrique instantanée de chacune des trois phases (L1, L2, L3) par rapport à un conducteur neutre (N) ,
- une unité de calcul (1) pour déterminer au moins la fréquence et la phase du réseau électrique,

dans lequel le dispositif de mesure emploie un procédé selon l'une quelconque des revendications 1 à 8, ou est préparé pour employer un tel procédé de mesure.

14. Dispositif d'injection pour injecter de l'énergie électrique dans un réseau de tensions alternatives, comportant,

- un dispositif de mesure, en particulier selon la revendication 13, pour mesurer des grandeurs électriques du réseau de tensions alternatives, et
- une unité d'injection pour injecter de l'énergie électrique dans le réseau de tensions alternatives,

dans lequel le dispositif d'injection emploie un procédé selon l'une quelconque des revendications 9 à 11 ou est préparé pour employer un tel procédé de mesure.

15. Installation éolienne pour transformer de l'énergie éolienne en énergie électrique et pour injecter l'énergie électrique dans un réseau de tensions alternatives comportant un dispositif de mesure selon la revendication 13 et/ou un dispositif d'injection selon la revendication 14.

FIG. 1

FIG. 2

FIG. 3

FIG. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10113786 A1
- EP 004984 A1
- WO 2008120282 A1
- DE 19944680 A1